Europäisches Patentamt

European Patent Office

Office européen des brevets

Publication number: **0 286 348**
**A2**

## EUROPEAN PATENT APPLICATION

Application number: **88303000.9**

Int. Cl.4 **H01L 27/14**

Date of filing: **05.04.88**

Priority: **10.04.87 US 37263**

Date of publication of application:
**12.10.88 Bulletin 88/41**

Designated Contracting States:
**DE FR GB NL**

Applicant: **AMERICAN TELEPHONE AND TELEGRAPH COMPANY**
**550 Madison Avenue**
**New York, NY 10022(US)**

Inventor: **Chang, Robert Pang Hend**
**2330 Iroquois Drive**
**Glenview Illinois 60025(US)**
Inventor: **Cheng, Chu-Liang**
**94 Ross Hall Boulevard**
**North Piscataway New Jersey 08854(US)**
Inventor: **Tell, Benjamin**
**36 Infield Lane**
**Aberdeen New Jersey 07747(US)**

Representative: **Buckley, Christopher Simon Thirsk et al**
**AT&T (UK) LTD. AT&T Intellectual Property Division 5 Mornington Road**
**Woodford Green, Essex IG8 OTU(GB)**

Vertically integrated photodetector-amplifier.

Monolithically integrated optical detector-amplifiers are described in which the detector-amplifier structure has vertical integration, and the amplifier is made of recessed gate MISFETS. The structure is planar which permits very fine line photolithography.

EP 0 286 348 A2

# VERTICALLY INTEGRATED PHOTODETECTOR-AMPLIFIER

## Technical Field

The invention is an integrated photodetector-amplifier device.

## Background of the Invention

The rapid development of optical technology, especially optical communication technology, has increased the importance of various kinds of optical devices. Particularly important among these optical devices are optical detectors. High sensitivity and high speed are among characteristics of importance for optical detectors used in optical communication systems. Also of importance are high signal gain and high reliability as well as ease in maintaining the optical detector device under typical commercial operating conditions.

Although a variety of integrated detector-amplifier (PIN-FET) structures are known, improvement in performance is highly desirable, and ease in fabrication highly desirable. Particularly desirable is a planar structure in which fine-line photolithography can be used to achieve the dimensional tolerance necessary for high speed response and high performance.

A number of references have described various kinds of integrated detector-amplifier devices. Particularly noteworthy are two references: one by K. Kasahara et al., entitled "Integrated PINFET Optical Receiver with High-Frequency InP-MISFET", Electronic Letters,, Vol. 19, pp. 905-906 (1983); and K. Kasahara et al., entitled "Monolithically Integrated InGaAs PIN/InP-MISFET Photoreceiver," Electronic Letters, Vol. 20, p. 314, (1984).

## Summary of the Invention

The invention is a monolithic integrated photodetector-amplifier (PIN-AMP) which is planar and is made from indium phosphide and II-V semiconductor compounds approximately lattice-matched to indium phosphide.

The basic feature of the structure is two or more epitaxial layers of III-V compound semiconductor material. One layer is an absorbing layer for radiation in the 1.1 to 1.7μ wavelength range and is generally made of $n^-$-InGaAs. The second layer is made of semi-insulating indium phosphide. These layers are generally mounted on a substrate with the absorbing layer between substrate and semi-insulating layer. The photodetector part of the structure is a PIN-type detector in which a p-type region extends into or through the semiinsulating layer of indium phosphide and optionally partially into the absorbing layer. The amplifier part of the structure is a MISFET (metal-insulator-semiconductor field-effect transistor) with a self-aligned gate. The MISFET structure is made up of an n-channel layer buried in the semi-insulating indium phosphide with a self-aligned gate in the middle. On each side of the gate electrode are the source and drain electrodes made up of a metal layer and highly doped ($n^+$) indium phosphide directly below the metal layer and above the channel layer. The self-aligned gate structure is made by undercutting an insulating layer ($Si_xN_y$) by etching through a hole in the insulating layer and depositing the gate insulator and electrode metal through the hole. The output of the PIN structure is usually connected to the gate electrode. Other structural features may also be incorporated into the same chip to make up preamplifier-type circuit. This type structure is highly advantageous principally because the planar structure permits very fine line photolithography necessary for high performance semiconductor transistors, in particular, FETs. Such performance is necessary for high sensitivity at high frequencies.

## Brief Description of the Drawing

FIG. 1 shows a planar monolithically integrated InGaAs PIN-amplifier featuring recessed gate indium phosphide MISFETS;

FIG. 2 shows a circuit using the PINFET shown in FIG. 1;

FIG. 3 shows a top view of the semiconductor chip of the circuit shown in FIG. 2;

FIG. 4 shows the current vs voltage characteristics of the PIN diode;

FIG. 5 shows the capacitance vs voltage characteristics of the PIN diode;

FIG. 6 shows the DC voltage transfer characteristics for the common source inverter stage; and

FIG. 7 shows the transfer characteristics of the buffer stage.

## Detailed Description

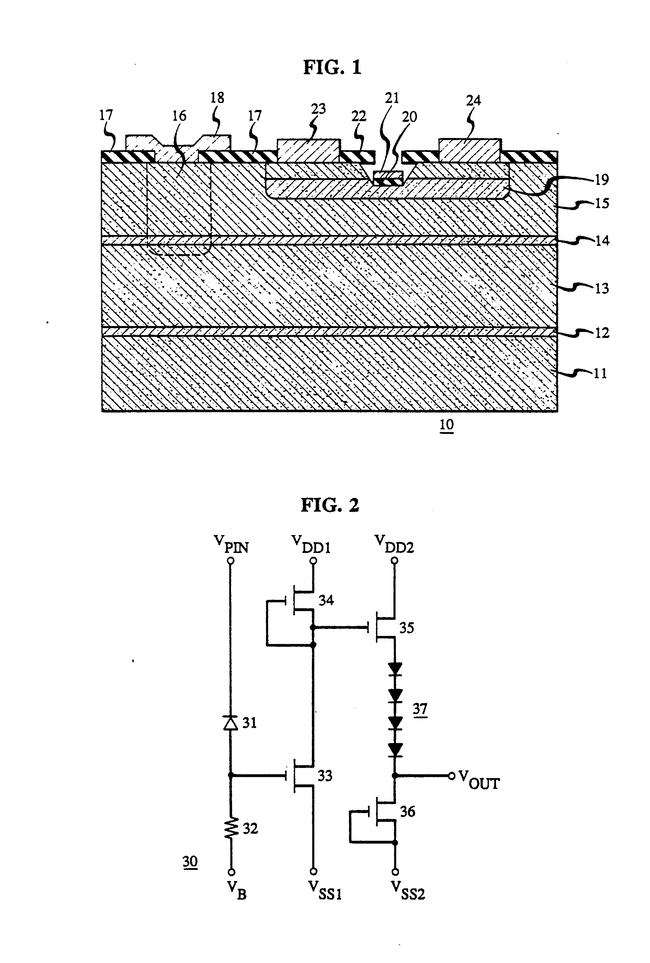

The basic structural feature of the optical detector-amplifier device 10 is shown in FIG. 1. This structural feature consists of a PIN-type photodetector and a MISFET-type amplifier. These features, as well as other optional structural features (further amplification stages, buffer stages, etc.) are formed on a substrate 11, generally made of $n^+$-InP. The $n^+$-InP substrate is generally made of InP doped with sulfur or tin, typically in the concentration range from $10^{17}$ to $5 \times 10^{18}$ atoms/cm$^3$. Other materials may be used for the substrate including semi-insulating InP and more lightly doped InP. A number of layers are grown on top of the substrate. First, there is a thin layer 12 (typically 0.5μm thick) of undoped InP buffer, then a 3μm thick layer 13 of undoped InGaAs (electron concentration less than $1 \times 10^{15}$ cm$^{-3}$) and a 0.5μm thick cap layer 14 of undoped InP. The buffer layer and cap layer are optional to improve interface characteristics and decrease the trap density between layers. These layers are usually grown by trichloride vapor phase epitaxy. This procedure is described in a number of references including H. M. Cox et al., Institute of Physics Conference, Serial No. 65, page 133 (1983), and V. D. Mattera et al., High Speed $InP/Ga_{0.47}In_{0.53}As$ Superlattice Avalanche Photodiodes with Very Low Background Doping Grown by Continuous Trichloride Vapor Phase Epitaxy", J. Applied Physics, Vol. 60, page 2609 (1986).

On top of the cap layer 14 is a semi-insulating layer 15 of InP, generally about 2.5 μm thick. This layer contains the MISFET part of the structure as well as other optional features in the structure. Typical resistivity of the Fe:InP layer is greater than $5 \times 10^7$ ohm-cm. The semi-insulating layer is generally grown by atmospheric pressure organometallic vapor phase epitaxy using vertical geometry, and the sources are trimethyl indium and phosphide with ferrocene used as the source of Fe. Atmospheric pressure organometallic vapor phase epitaxy is described in a number of references including J. L. Zilko et al., "The Effect of Gas Temperature on the Growth of InP by Atmospheric Pressure Metal-Organic Chemical Vapor Deposition Using Trimethyl Indium and $PH_3$ Sources:, J. Electron Materials, Vol. 14, page 563 (1985), and J. A. Long et al., "Growth of Fe-Doped Semi-Insulating InP by MOCVD:, J. Crystal Growth, Vol. 69, page 10 (1984).

Two points need some further discussion. The absorption layer, labled the $n^-$-InGaAs layer 13 may be made of other materials that absorb the radiation to be detected and produce electric currents. The $n^-$-InGaAs (approximate composition $In_{0.53}Ga_{0.47}As$) absorbs radiation and is therefore suitable up to about 1.65μm wavelengths. Quaternary III-V semiconductor compound materials are also useful as the absorption layer. For example, $In_{0.73}Ga_{0.27}As_{0.6}P_{0.4}$ is lattice-matched to InP and is useful as the absorbing layer up to wavelengths about 1.3μm. Other materials and material compositions may be useful in the absorbing layer.

The thickness of the layers may vary over large limits, and optimum thickness often depends on material characteristics and growth limitations. For example, the optimum thickness of the absorbing layer depends on the absorption of the radiation in the layer and carrier concentration. For the carrier concentration of available InGaAs, optimum thickness is about 3μm. For much lower carrier concentration, optimum thickness might be much greater, typically up to 5, 10 or even 20μm. For higher carrier concentration, thinner layers (e.g. 0.5μm) might be optimum.

For the semi-insulating layer, optimum thickness is probably determined by growth procedure; but, once again, thicknesses up to 5, 10 or even 20μm might be useful. In FIG. 1, the thickness is about 2.5μm.

Various features of the device structure are located in the semi-insulating InP (S.I.InP) layer 15 and at times extending through the cap layer 14. The PIN-detector feature is located in one part of the S.I.InP layer. It consists of a p-conducting region 16 extending from the surface of the S.I.InP layer 15, through the S.I.InP layer 15 and through the cap layer 14, and into the absorption layer 13. The p-conductivity region is usually made by diffusion doping, most often with zinc dopant. The surface of the S.I.InP layer adjacent to the p-region is covered with a dielectric 17, typically $Si_xN_y$. A metal contact 18, typically gold-zinc serves as a p-contact on top of the p-region 16.

A word about the p-contact on the PIN detector is in order. The metal contact shown in FIG. 1 overlaps part of the dielectric and has no hole to admit the radiation to be detected. Two variations are possible. First, if radiation is to be admitted from the top of the device, a hole is needed in the p-contact to admit radiation. Also, a smaller size for the p-contact might reduce unwanted capacitance. A typical shape is a donut shape with windows in the center for admission of radiation and between metal and dielectric 17.

The amplifier section is located adjacent to the PIN-detector section in the semi-insulating InP layer 15. The amplifier section is a recessed gate InP MISFET. This structure consists of a channel layer 19 with the gate insulator 20 and gate metal 21 located in the middle of the channel layer, and beneath an overhanging dielectric layer 22. The channel layer 19 is usually doped with silicon by ion implantation usually in the concentration range of approximately $10^{17}$ atoms/cm$^3$. The gate insulator material may be made of a variety of materials including aluminum oxide and silicon dioxide. Aluminum phosphorous oxide is particularly useful as the gate insulator. On each side of the recessed gate are located the source electrode 23 an drain electrode 24. These are typically made of gold germanium, and the regions directly below the electrodes are highly doped with n-type dopant to ease the ohmic contact of metal electrodes. The dopant is typically silicon in the concentration range of approximately $2 \times 10^{18}$ atoms/$cm^3$. The gate metal is generally made of chrome-gold or aluminum. The p-contact of the PIN detector is connected electrically to the gate electrode.

Further features of the device are generally incorporated into the semi-insulating InP layer. Ion implantation is usually used to alter the conductivity characteristics of the insulating layer, and various types of metal deposition are used to produce conductor paths. FIG. 2 shows a circuit diagram 30 of a typical circuit incorporating the PINFET structure described above. The PIN photodetector 31 is in series with a resistor 32. Light incident on the PIN detector causes a current to flow through the resistor 32 which develops a voltage on the gate of the active FET 33 also shown in FIG. 1. This produces a stage of amplification in which the load FET acts as a load resistor. The output of this stage is fed into a buffer stage consisting of an active FET 35 and a load FET 36. A series of diodes 37 (here exemplified by 4 diodes) are used to shift the D.C. voltage level from near three volts at the output of the amplification stage to close to zero D.C. volts at the output of the buffer stage ($V_{out}$). Various potentials are supplied to the circuit. Typical values are as follows:

$V_{PIN}$ = +5 volts,

$V_{DD1}$ = +5, $V_{SS1}$ = 0, $V_{DD2}$ = +5 volts , and

$V_{SS2}$ = -3 volts.

This preamplifier circuit is exemplatory of the use of the PINFET described in FIG. 1. Other circuits could also be used.

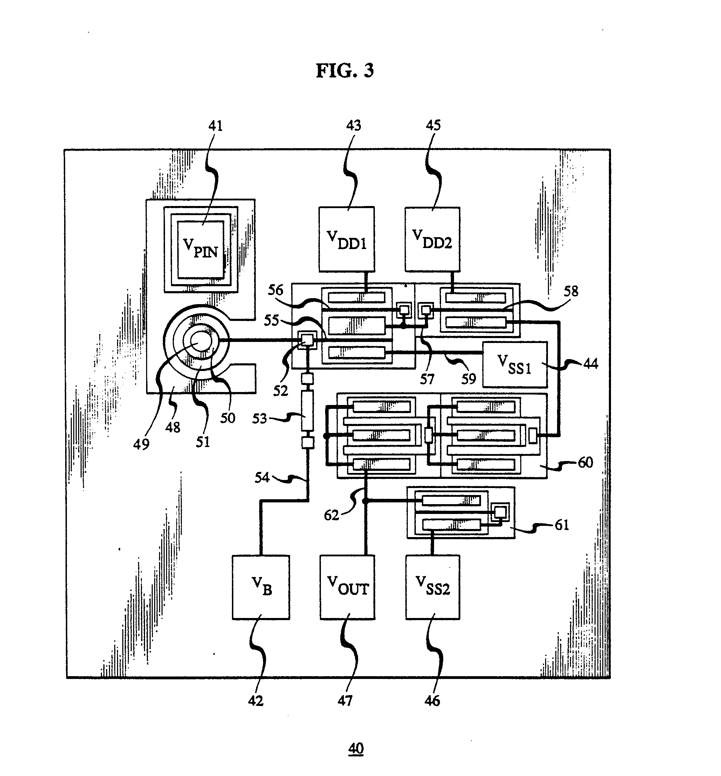

FIG. 3 shows a top view of the semiconductor chip containing the circuit described in FIG. 2. This view is often called the mask pattern of the chip. Shown on the chip pattern are a number of pads corresponding to DC bias and output terminals in the circuit shown in FIG. 2. These are the $V_{PIN}$ pad 41, the $V_B$ pad 42, the $V_{DD1}$ pad 43, the $V_{SS1}$ pad 44, the $V_{DD2}$ pad 45, the $V_{SS2}$ pad 46, and the $V_{OUT}$ pad 47. The PIN part 48 of the circuit is located on the top left part of the chip and consists of an opening 49 in the metal electrode and a donut-shaped p-contact 50. Also shown (both under and to the side of the p-contact 50) is the p-conductivity region 51 which is part of the PIN junction. The p-contact is electrically connected 52 to the gate of the MISFET shown 21 in FIG. 1 and labeled 33 in FIG. 2. Also shown is electrical connection to the resistor 53 and the electrical connection 54 to the $V_B$ pad 42 corresponding to the to the PIN section shown in FIG. 2. Also shown are the active 55 and a load 56 FETs of the amplifier sections corresponding to the active 33 and load 34 FETs of FIG. 2. The gate and source of the load FET 56 is electrically connected 57 to the gate 58 of the active FET of the buffer stage (35 in FIG. 2). The source of the active FET 55 of the amplification stage is electrically connected to the $V_{SS1}$ pad 44 by means of a conductor 59. The buffer state is made up of an active FET 58 (35 in FIG. 2), a series of diodes 60 (37 in FIG. 2) and a load FET 61 (36 in FIG. 2). One side of the diode string 60 and the drain of the load FET 61 are connected together 62, as well as to the $V_{OUT}$ pad.

Many other circuit arrangements are possible using the combination of PIN photodiode and MISFET amplifier shown in FIG. 1.

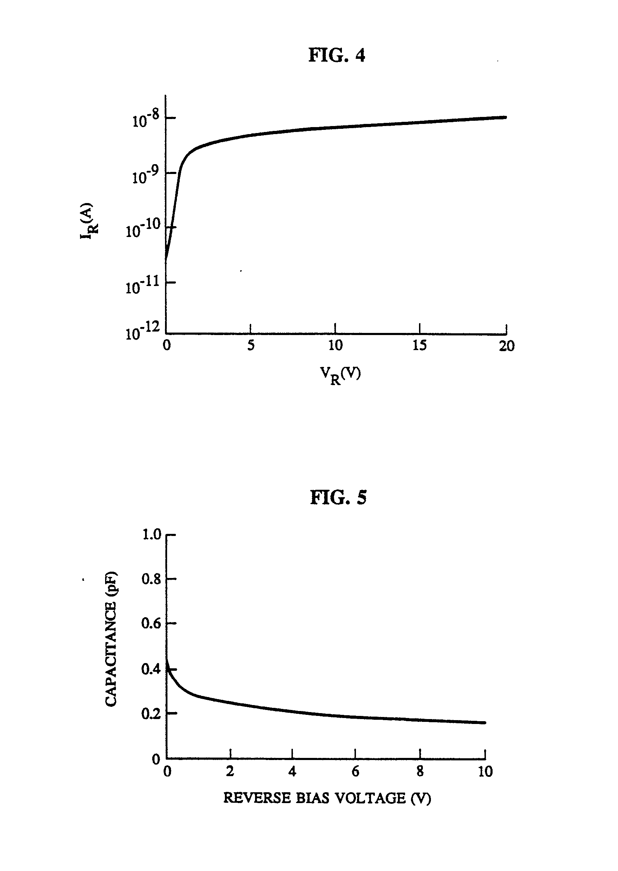

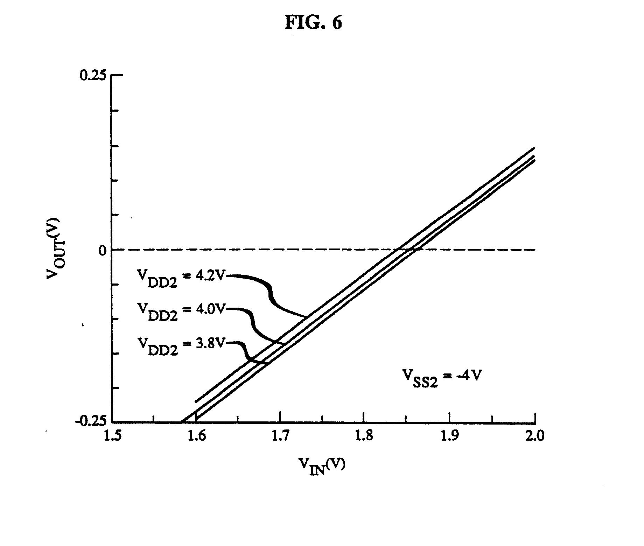

Typical reverse current-voltage (I-V) and capacitance-voltage (C-V) characteristics of the PIN diodes are shown in FIGS. 4 and 5. The PIN diode is of planar structure, and the leakage current is well below 10 nA at -10 V bias. leakage current as low as 100 pA at -10 V has been observed. The depletion capacitance is less than 0.2 pF below -5 V bias. The quantum efficiency at 1.3μm wavelength is over 70% with index-matching epoxy. These results are similar to those of the PIN diodes fabricated from wafers with only trichloride VPE layers. In fact, the semi-insulating InP as a cap layer may help to reduce the leakage current.

The InP MISFET device is 100μm wide with a gate length of 1μm. It can be operated both in the enhancement and depletion mode. The I-V curves show little hysteresis and complete pinch-off at -2 V. Near zero gate bias, the transconductance is approximately 6 mS, i.e., 60 mS/mm. The gate capacitance at zero bias is approximately 0.15 pF. The I-V characteristics of the load FET with gate and source connected together are also exceptionally good. The gate length is 3μm, and the width is also 100μm. The drain saturation current $I_{DSS}$ of the load FET is around 9 mA which is slightly lower than that of the active FET of 10 mA. Both FETs have output impedances higher than 2 KΩ.

The dc voltage transfer characteristic for the common source inverter stage is of interest. The drain bias voltage is varied from 3.5V to 6.5V, and the maximum gain is approximately 7.2 when biased at 6.5V. This agrees with the calculated gain of A = $gm \times (R_{out}//R_{load})$, where

$gm$ = $6mS$ and $(R_{out}//R_{load}$ = 1.2kΩ. FIG. 6 shows the transfer characteristics of the buffer stage with four level-shifting diodes. The input is swept from 1.5V to 2.0V, which corresponds to the output voltage of the inverter stage with a supply voltage between 4.5V and 5.5V. The gain of this buffer stage is about 0.8. The four level-shifting diodes are made of Au/Cr-InP Schottky diodes. and a total series resistance of ~120Ω, leaving much room for improvement. An alternative approach which is expected to have higher turn-on voltages, although with some increase in processing complexity, is to use InP junction diodes. The output impedance is estimated to be approximately 300Ω, but it can be reduced to close to 50Ω when the amplifier is connected in a transimpedance configuration.

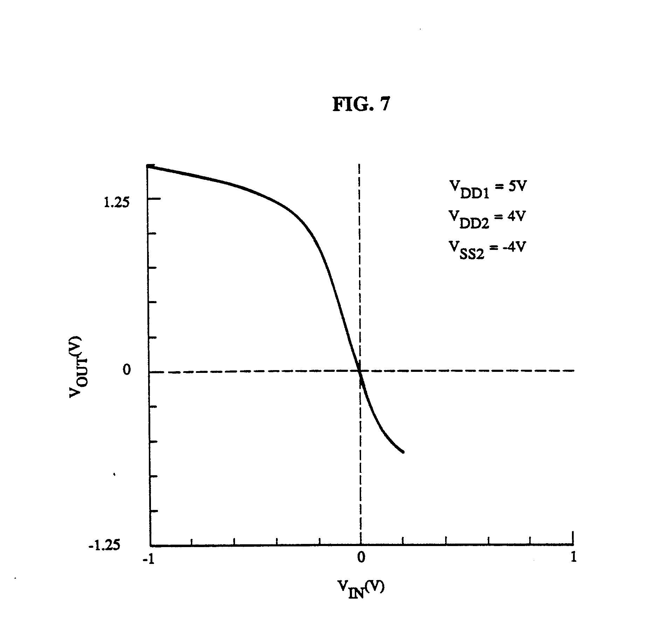

The voltage transfer characteristics of both inverter and buffer stages together were also measured and shown in FIG. 7. The total gain is approximately 5 (14 dB). It is apparent that the output dc voltage can be very close to zero when the input voltage is zero, provided the amplifier is biased properly. The linear gain range of about 0.3V corresponds to a maximum input optical signal of ~30$\mu$W.

The response of the detector-amplifier combination to optical signals are also of interest. This type of measurement is made using a high speed CSBH laser (1.55$\mu$m wavelength) and observing the output of the detector-amplifier combination. The rise and fall times are estimated to be 20 mp and 15 mp, respectively. The RC time constant is therefore approximately 10ns, and the bandwidth is approximately 18 MHz.

The PIN-AMP sensitivity was measured at 400 Mb/s and 1.55 $\mu$m wavelength. The integrated received signal was equalized and further amplified. The bias condition fort the PIN-AMP is adjusted to achieve the best sensitivity, not necessarily for the highest gain of the amplifier. At a $10^{-9}$ bit-error rate, the receiver sensitivity is approximately -27 dBm.

## Claims

1. An optical-semiconductor device for converting radiation into electrical signal comprising detector-amplifier section comprising:

a. an absorption region comprising at least one III-V compound semiconductor capable of absorbing radiation;

b. a semi-insulating semiconductor region comprising indium phosphide and contacting at least a portion of the absorption region;

c. an InP substrate region contacting at least a portion of the absorption region;

d. a PIN region comprising p-conductivity region extending from the surface of the semi-insulating semiconductor region, and into the semi-insulating semiconductor region and contacting the absorption region, a p-contact contacting the p-conductivity region and an n-contact;

e. a MISFET region contained in the semi-insulating semiconductor region comprising

1. a channel region comprising n-type InP contacting the semi-insulating semiconductor region;

2. a gate region comprising insulator region and gate electrode, said insulator region contacting the channel region and said gate electrode contacting said insulator region, said gate region located in a groove below an overhanging insulator region so as to form a self-aligned structure;

3. a source region comprising $n^+$ InP source region and source electrode, said $n^+$ InP source region contacting said channel region and said source electrode contacting said $n^+$ InP source region;

4. a drain region comprising $n^+$ InP drain region and drain electrode, said $n^+$ InP drain region contacting said channel region and said drain electrode contacting said $n^+$ InP drain region;

f. electrical connection between p-contact or n-contact in the PIN region and gate electrode.

2. The device of claim 1 in which the absorption region comprises a compound selected from the group consisting of InGaAs and InGaAsP with composition that is lattice-matched to InP.

3. The device of claim 2 in which the absorption region comprises InGaAs lattice-matched to InP.

4. The device of claim in which the semi-insulating semiconductor region comprises Fe-doped InP.

5. The device of claim 1 in which the dopant in the p-conductivity region is zinc.

6. The device of claim 1 in which p-contact comprises gold-zinc alloy.

7. The device of claim 1 in which the p-contact has a hole in it to admit radiation.

8. The device of claim 7 in which the p-contact is shaped like a donut.

9. The device of claim 1 in which the InP substrate region is a substrate.

10. The device of claim 9 in which the InP substrate region comprises $n^+$-InP. in the $n^+$-InP is sulfur or tin in the concentration range from $10^{17}$ to $5 \times 10^{18}$ atoms/$cm^3$.

11. The device of claim 1 in which the channel region is doped with silicon at a concentration of approximately $10^{17}$ atoms/$cm^3$.

12. The device of claim 1 in which a cap region is between the absorption region and the semi-insulating semiconductor region.

13. The device of claim 1 in which a buffer region is between the absorption region and the $n^+$-InP substrate region.

14. The device of claim 1 in which the p-contact is electrically connected to the MISFET gate.

15. The device of claim 1 in which, in addition, the p-contact or n-contact is connected to a resistor and the MISFET is connected to a load field effect transistor.

16. The device of claim 15 in which the load field effect transistor is connected to a buffer stage.

## FIG. 1

## FIG. 2

# FIG. 3

40

## FIG. 4

## FIG. 5

**FIG. 6**

**FIG. 7**

$V_{DD1} = 5V$

$V_{DD2} = 4V$

$V_{SS2} = -4V$